# EUROPEAN PATENT APPLICATION

(11) **EP 4 761 103 A1**
(43) Date of publication of application: **17.06.2026**
(21) Application number: 24307097.6
(22) Date of filing: 13.12.2024
(51) Int. Cl.: H03F 1/02, H03F 1/56, H03F 3/195, H03F 3/24

(54) **RADIO FREQUENCY POWER AMPLIFIERS AND POWER AMPLIFIER DEVICES WITH IMPEDANCE MATCHING CIRCUITS**

(71) Applicant: NXP USA, Inc., Austin TX 78735 (US)
(72) Inventor: Bollinger, Laure, 31023 Toulouse (FR); Le Viavant, Nicolas, 31023 Toulouse (FR)
(74) Representative: Schwarzweller, Thomas

(57) **Abstract**

A radio frequency (RF) power amplifier (100, 200) and a packaged power amplifier device include a transistor (130, 230, 530) and an input impedance matching circuit (110, 210, 310) coupled between an amplifier input and an input terminal of the transistor. The input impedance matching circuit includes first, second, third, and fourth inductive elements (111, 112, 113, 114, 211, 212, 213, 214, 411, 412, 413, 414) coupled in series, with first, second, third intermediate nodes (118, 119, 120, 218, 219, 220, 418, 419, 420) between adjacent inductive elements. First, second, and third capacitors (115, 116, 117, 215, 216, 217, 415, 416, 417) are coupled between the first, second, and third intermediate nodes, respectively, and a ground reference node.

## Description

### TECHNICAL FIELD

Embodiments of the subject matter described herein relate generally to radio frequency (RF) amplifiers, and more particularly to amplifiers and power amplifier devices with impedance matching circuits.

### BACKGROUND

Wireless communication systems employ power amplifiers for increasing the power of radio frequency (RF) signals. In a cellular base station, for example, a Doherty power amplifier may form a portion of the last amplification stage in a transmission chain before provision of the amplified signal to an antenna for radiation over the air interface. High gain, high linearity, stability, and a high level of power-added efficiency are characteristics of a desirable power amplifier in such a wireless communication system.

In the field of power amplifier device design, it is becoming increasingly desirable to achieve wideband operation at the fundamental frequency while controlling signal energy at harmonic frequencies. In addition, an ever present trend is toward miniaturizing amplifier circuits. However, achieving wideband operation with good harmonic control in a small form factor, all while maintaining good RF performance, continues to provide challenges to power amplifier designers.

### SUMMARY

According to a first aspect of the present disclosure, there is provided a radio frequency (RF) power amplifier that includes a first amplification path, a first transistor, and a first impedance matching circuit. The first amplification path has a first amplifier input and a first amplifier output. The first transistor has a first transistor input terminal and a first transistor output terminal. The first input impedance matching circuit is coupled between the first amplifier input and the first transistor input terminal, and the first input impedance matching circuit includes a first inductive element coupled between the first amplifier input and a first intermediate node, a first capacitor coupled between the first intermediate node and a ground reference node, a second inductive element coupled between the first intermediate node and a second intermediate node, a second capacitor coupled between the second intermediate node and the ground reference node, a third inductive element coupled between the second intermediate node and a third intermediate node, a third capacitor coupled between the third intermediate node and the ground reference node, and a fourth inductive element coupled between the third intermediate node and the first transistor input terminal.

In one or more embodiments the RF power amplifier also includes a baseband termination circuit connected to the third intermediate node, wherein the baseband termination circuit includes a plurality of components, and the plurality of components includes an envelope resistor, an envelope inductor, and an envelope capacitor coupled in series between the third intermediate node and the ground reference node.

In one or more embodiments, the RF power amplifier also includes a first output impedance matching circuit coupled between the first transistor output terminal and the first amplifier output, where the first output impedance matching circuit includes a fifth inductive element coupled between the first transistor output terminal and the first amplifier output, a sixth inductive element coupled between the first transistor output terminal and a fourth intermediate node, and a fourth capacitor coupled between the fourth intermediate node and the ground reference node.

In one or more embodiments, the RF power amplifier is a Doherty power amplifier that further includes a second amplification path, a power divider, and a combining node. The second amplification path includes a second amplifier input, a second amplifier output, a second transistor, and a second input impedance matching circuit. The power divider has a power divider input configured to receive an RF input signal, a first power divider output coupled to an input of the first amplification path, and a second power divider output coupled to the second amplifier input, and the power divider is configured to divide the RF input signal into a first RF signal that is provided to the first amplification path through the first power divider output, and into a second RF signal that is provided to the second amplification path through the second power divider output. The combining node is configured to receive and combine amplified RF signals produced by the first and second amplification paths.

In one or more embodiments, the second input impedance matching circuit includes a fifth inductive element coupled between the second amplifier input and a fourth intermediate node, a fourth capacitor coupled between the fourth intermediate node and the ground reference node, a sixth inductive element coupled between the fourth intermediate node and a fifth intermediate node, a fifth capacitor coupled between the fifth intermediate node and the ground reference node, a seventh inductive element coupled between the fifth intermediate node and a sixth intermediate node, a sixth capacitor coupled between the sixth intermediate node and the ground reference node, and an eighth inductive element coupled between the sixth intermediate node and a second transistor input terminal of the second transistor.

According to a second aspect of the present disclosure, there is provided a packaged RF power amplifier device that includes a device substrate, a first input lead coupled to the device substrate, a first output lead coupled to the device substrate, a first transistor die coupled to the device substrate, and a first input impedance matching circuit. The first transistor die includes a first transistor, a transistor input terminal coupled to the first input lead, and a transistor output terminal coupled to the first output lead. The first input impedance matching circuit is coupled between the first input lead and the first transistor input terminal, and the first input impedance matching circuit includes a first inductive element coupled between the first input lead and a first intermediate node, a first capacitor coupled between the first intermediate node and a ground reference node, a second inductive element coupled between the first intermediate node and a second intermediate node, a second capacitor coupled between the second intermediate node and the ground reference node, a third inductive element coupled between the second intermediate node and a third intermediate node, a third capacitor coupled between the third intermediate node and the ground reference node, and a fourth inductive element coupled between the third intermediate node and the transistor input terminal.

In one or more embodiments, each of the first, second, third, and fourth inductive elements includes a plurality of wirebonds.

In one or more embodiments, the packaged RF power amplifier device also includes one or more integrated passive devices coupled to the device substrate between the first input lead and the first transistor die, where each of the first, second, and third capacitors are integrally formed in the one or more integrated passive devices.

In one or more embodiments, each of the first, second, and third intermediate nodes corresponds to a bond pad of the one or more integrated passive devices.

In one or more embodiments, the packaged RF power amplifier device of also includes a first baseband termination circuit integrally formed in the one or more integrated passive devices, where the first baseband termination circuit includes a first plurality of components, and the first plurality of components includes a first envelope resistor, a first envelope inductor, and a first envelope capacitor coupled in series between the third intermediate node and the ground reference node.

In one or more embodiments, the first input lead, the first output lead, the first transistor, and the first input impedance matching circuit form portions of a first amplifier path, and the packaged RF power amplifier device further includes a second amplification path that includes a second input lead coupled to the device substrate, a second output lead coupled to the device substrate, a second transistor die coupled to the device substrate, wherein the second transistor die includes a second transistor coupled between the second input lead and the second output lead, and a second input impedance matching circuit coupled between the second input lead and the second transistor. The second input impedance matching circuit includes a fifth inductive element coupled between the second input lead and a fourth intermediate node, a fourth capacitor coupled between the fourth intermediate node and the ground reference node, a sixth inductive element coupled between the fourth intermediate node and a fifth intermediate node, a fifth capacitor coupled between the fifth intermediate node and the ground reference node, a seventh inductive element coupled between the fifth intermediate node and a sixth intermediate node, a sixth capacitor coupled between the sixth intermediate node and the ground reference node, and an eighth inductive element coupled between the sixth intermediate node and the transistor input terminal.

### BRIEF DESCRIPTION OF THE DRAWINGS

A more complete understanding of the subject matter may be derived by referring to the detailed description and claims when considered in conjunction with the following figures, which are not necessarily drawn to scale, and wherein like reference numbers refer to similar elements throughout the figures.
FIG. 1 is a schematic circuit diagram of a radio frequency (RF) power amplifier, in accordance with one or more example embodiments;
FIG. 2 is a schematic circuit diagram of a Doherty power amplifier, in accordance with one or more example embodiments;
FIG. 3 is a top view of a packaged RF power amplifier device, in accordance with one or more example embodiments;
FIG. 4 is a top view of an enlarged portion of the packaged RF power amplifier device of FIG. 3;
FIG. 5 is a cross-sectional, side view of the portion of the RF power amplifier device of FIG. 4 along line 5-5, in accordance with one or more example embodiments; and
FIGs 6A and 6B are Smith charts comparing fundamental input impedance transformations of power amplifiers with and without embodiments of input impedance matching circuits described herein.

### DETAILED DESCRIPTION

Embodiments of power amplifiers and power amplifier devices described herein may be capable of achieving wideband operation at the fundamental frequency while controlling signal energy at harmonic frequencies. According to one or more embodiments, this is achieved using an input impedance matching circuit with a "triple T-match" configuration. In comparison with conventional devices (with conventional input impedance matching circuits), embodiments of power amplifiers and power amplifier devices described herein include input impedance matching circuits that have better impedance matching at the fundamental frequency of operation. Specifically, the input impedance matching circuit embodiments may be characterized by reduced parasitic inductance and thus a better Q factor (quality factor), which may result in reduced losses and improved gain, in comparison with conventional amplifiers and devices. In addition, the various embodiments may enable higher real part impedances to be achieved at the lead plane, which may make the system substrate (e.g., printed circuit board, PCB) matching at the lead plane of the power amplifier easier. Embodiments of power amplifier devices described herein implement such input impedance matching circuits internal to the device, rather than on the system substrate to which the device is attached. Accordingly, space on the system substrate is conserved, and the power amplifier devices with the impedance matching circuit embodiments enable overall amplifier size to be relatively small.

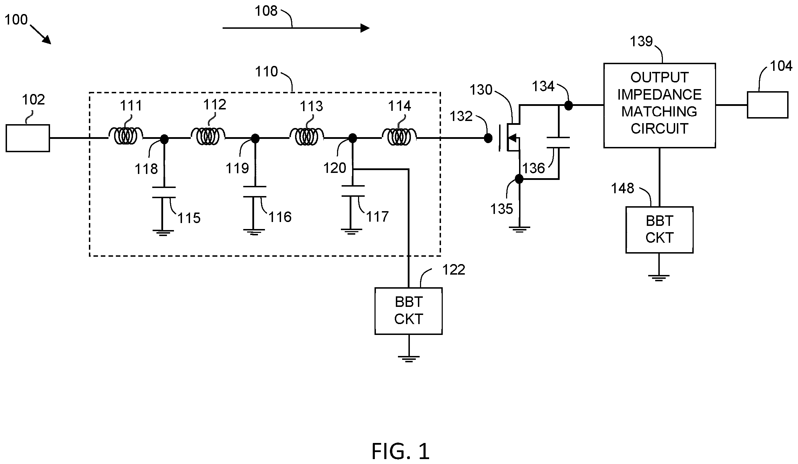

FIG. 1 is a schematic diagram of an RF power amplifier 100, in accordance with one or more example embodiments. Circuit 100 includes an amplification path 108 with a series-coupled arrangement of an amplifier input 102, an input impedance matching circuit 110, a transistor 130, an output impedance matching circuit 139, and an amplifier output 104. According to one or more further embodiments, RF power amplifier 100 also may include an input-side baseband termination circuit 122 (BBT CKT) and/or an output-side baseband termination circuit 148. The input impedance matching circuit 110 and the input-side baseband termination circuit 122 may be referred to collectively as an "input circuit." Similarly, the output impedance matching circuit 139 and the output-side baseband termination circuit 148 may be referred to collectively as an "output circuit."

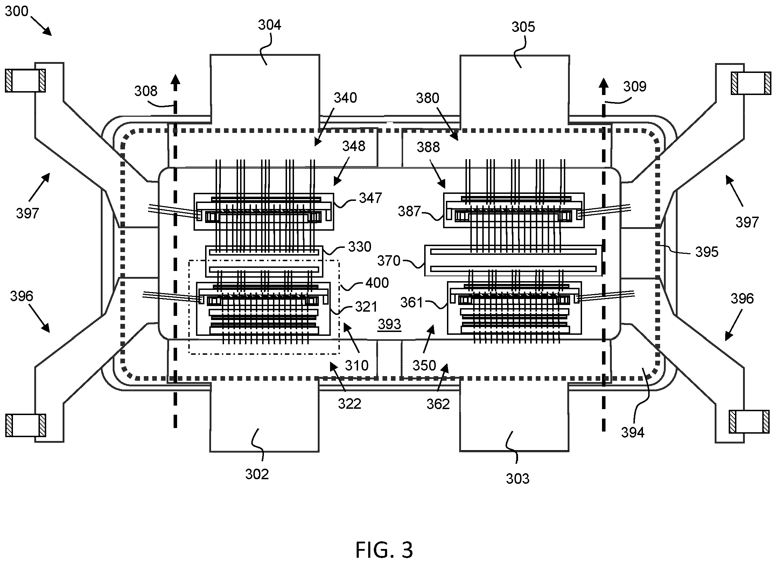

Input 102 and amplifier output 104 each may include a conductor (e.g., a package lead 302-305, FIG. 3), which is configured to enable the amplifier 100 to be electrically coupled with external circuitry (not shown). The input impedance matching circuit 110 and the input-side baseband termination circuit 122 (when included) are electrically coupled between the amplifier input 102 and a first terminal 132 of transistor 130 (e.g., a gate terminal of transistor 130). The input impedance matching circuit 110 is configured to raise the impedance of amplifier 100 to a higher (e.g., intermediate or higher) impedance level (e.g., in a range from about 2 to about 10 Ohms or higher). This is advantageous in that it allows the printed circuit board level (PCB-level) matching interface (e.g., from a driver stage) to have an impedance that can be achieved in high-volume manufacturing with minimal loss and variation (e.g., a "user friendly" matching interface).

According to an embodiment, input impedance matching circuit 110 has a "triple T-match" configuration. This configuration includes first, second, third, and fourth inductive elements 111, 112, 113, 114 with first, second, and third shunt capacitors 115, 116, 117 coupled to intermediate nodes 118, 119, 120 between the inductive elements 111-114. As used herein, the term "shunt" means coupled between a circuit node and a ground reference node (or another voltage reference). The embodiment of input impedance matching circuit 110 shown in FIG. 1 more specifically includes the first inductive element 111 coupled between the amplifier input 102 and the first intermediate node 118, the first shunt capacitor 115 coupled between the first intermediate node 118 and a ground reference node, the second inductive element 112 coupled between the first intermediate node 118 and the second intermediate node 119, the second shunt capacitor 116 coupled between the second intermediate node 119 and the ground reference node, the third inductive element 113 coupled between the second intermediate node 119 and the third intermediate node 120, the third capacitor 117 coupled between the third intermediate node 120 and the ground reference node, and the fourth inductive element 114 coupled between the third intermediate node 120 and the first transistor input terminal 132. It should be understood that, although FIG. 1 shows an embodiment of an input impedance matching circuit 110 with three T-match circuits (a "triple T-match" configuration), one or more additional components may be included in the input impedance matching circuit 110, in other embodiments (e.g., additional inductive elements, capacitors, and/or T-match circuits). Accordingly, embodiments of input impedance matching circuit 110 are not limited to having only three T-match circuits.

The first and second inductive elements 111, 112 and the first shunt capacitor 115 form a first T-match circuit. The second and third inductive elements 112, 113 and the second shunt capacitor 116 form a second T-match circuit. Finally, the third and fourth inductive elements 113, 114 and the third shunt capacitor 117 for a third T-match circuit.

The first T-match circuit (coupled to the input 102) functions as a low pass filter that is configured to provide impedance matching at the fundamental frequency of operation of the amplifier 100. According to one or more embodiments, the third T-match circuit (coupled to the transistor gate 132) functions as a low pass filter that may place the second harmonic impedance in a region away from a short circuit to ensure a good AM/AM profile and higher efficiency. The second T-match circuit also functions as a low pass filter, and helps to optimize (tune) the location of the second harmonic impedance. Desirably, the second and third T-match circuits function together to place the second harmonic impedance (at the Z_source extrinsic plane) close to a short circuit at the second harmonic frequency. Ideally, the second harmonic impedance is placed in the capacitive region of the Smith chart for the desired frequency of operation. However, the second harmonic impedance also can be placed in the inductive region. The third harmonic impedance may be placed in the inductive area of the Smith chart, although the third harmonic impedance location has a limited impact on output performance, when compared to the impact of the location of the second harmonic impedance. In particular, embodiments of amplifier 100 are characterized by second and third harmonic locations that are between -90 degrees and -180 degrees (at Zload at the current source plane of the PA), where the harmonic locations are preferably closer to a short circuit. This class of operation may be referred to as class BJ operation, although amplifier 100 is not limited to operating in class BJ.

According to an embodiment, each of inductive elements 111-114 may have an inductance value in a range between about 30 picohenries (pH) to about 750 pH, and each of shunt capacitors 115-117 may have a capacitance value in a range between about 2 picofarads (pF) to about 140 pF. In some embodiments, compared with shunt capacitors 115 and 116, shunt capacitor 117 may have a relatively-large capacitance (e.g., greater than 10 pF but less than 140 pF) to provide an acceptable RF low-impedance point at intermediate node 120. A point in an RF circuit that is characterized by very low impedance for RF signal energy may be referred to as an "RF cold point." According to one or more embodiments, intermediate node 120 is not a "perfect" RF cold point, in that some voltage at RF frequencies may be present at intermediate node 120 during operation. Accordingly, the intermediate node 120 may be referred to herein as a "quasi RF cold point."

According to an embodiment, an input-side baseband termination circuit 122 (BBT CKT) is coupled between intermediate node 120 (e.g., or an RF low-impedance point at or coupled to node 120) and the ground reference node. Baseband termination circuit 122 may function to improve the low frequency resonance (LFR) of amplifier 100 by presenting a low impedance at envelope frequencies and/or a high impedance at RF frequencies. Baseband termination circuit 122 essentially may be considered to be "invisible" from an RF matching standpoint, as it primarily effects the impedance at envelope frequencies (i.e., baseband termination circuit 122 provides terminations for the envelope frequencies of amplifier 100).

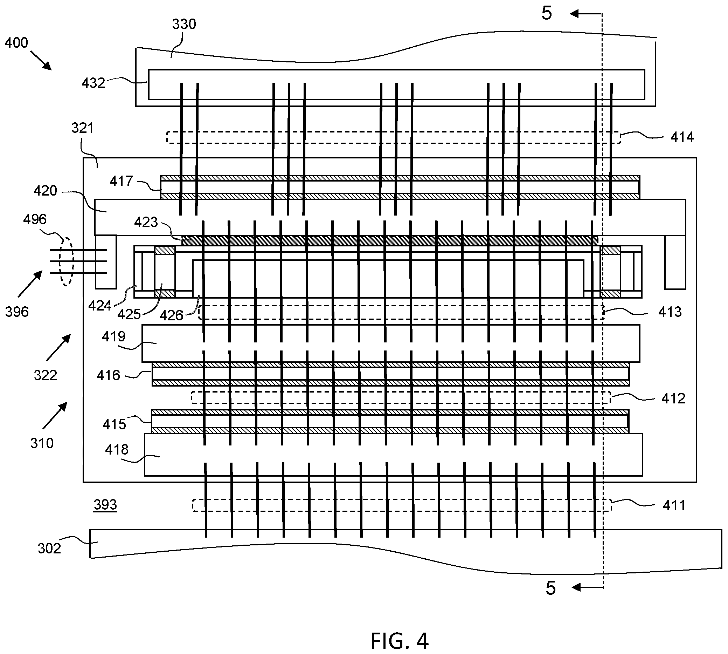

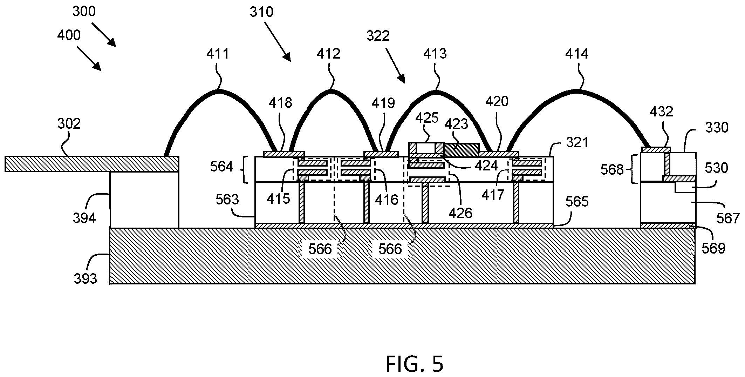

The baseband termination circuit 122 may have any of a number of different circuit configurations, in various embodiments. For example, referring briefly to FIG. 4 (which will be discussed in detail later), the baseband termination circuit 122 (referred to with reference number 322 in FIG. 4) may include an envelope resistor 423, an envelope inductor 424, and an envelope capacitor 426, coupled in series between an intermediate node 420 (e.g., corresponding to node 120, FIG. 1) and a ground reference node (e.g., conductive layer 565, FIG. 5). In some embodiments, a bypass capacitor 425 may be electrically coupled across one or more of the envelope inductor 423 and the envelope resistor 424.

Referring again to FIG. 1, and according to an embodiment, the transistor 130 is the primary active component of amplifier 100. Transistor 130 includes a control terminal 132 and two current conducting terminals 134, 135, where the current conducting terminals 134, 135 are spatially and electrically separated by a variable-conductivity channel. For example, transistor 130 may be a field effect transistor (FET), which includes a gate (control terminal 132), a drain (a first current conducting terminal 134), and a source (a second current conducting terminal 135). According to an embodiment, and using nomenclature typically applied to FETs in a nonlimiting manner, the gate 132 of transistor 130 is coupled to the amplifier input 102 through the input impedance matching circuit 110 and the input-side baseband termination circuit 122 (when included), the drain 134 of transistor 130 is coupled to the amplifier output 104 through the output impedance matching circuit 139 and the baseband termination circuit 148 (when included), and the source 135 of transistor 130 is coupled to ground (or another voltage reference). Through the variation of control signals provided to the gate of transistor 130, the current between the source and drain terminals 135, 134 of transistor 130 may be modulated.

According to various embodiments, transistor 130 may be a III-V field effect transistor (FET) (e.g., a high electron mobility transistor (HEMT)), which has a relatively low drain-source capacitance, *Cds,* when compared with a silicon-based FET (e.g., a laterally diffused metal oxide semiconductor (LDMOS) FET). In FIG. 1, the drain-source capacitance of transistor 130 is represented with capacitor 136 between the drain and source terminals 134, 135 of transistor 130. More specifically, capacitor 136 is not a physical component, but instead models the drain-source capacitance of transistor 130. According to an embodiment, transistor 130 may have a drain-source capacitance that is less than about 0.2 picofarads per millimeter (pF/mm) to about 0.3 pF/mm (e.g., meaning 0.02 pF per watt (pF/W) to about 0.03 pF/W, assuming that the power density is about 10 W/mm, on average, although this value may depend on the class of operation, such as Class F versus Class F-1). Further, in some embodiments, transistor 130 may be a gallium nitride (GaN) FET, although in other embodiments, transistor 130 may be another type of III-V transistor (e.g., gallium arsenide (GaAs), gallium phosphide (GaP), indium phosphide (InP), or indium antimonide (InSb)), or another type of transistor altogether (e.g., a silicon-based LDMOS FET, or another suitable transistor).

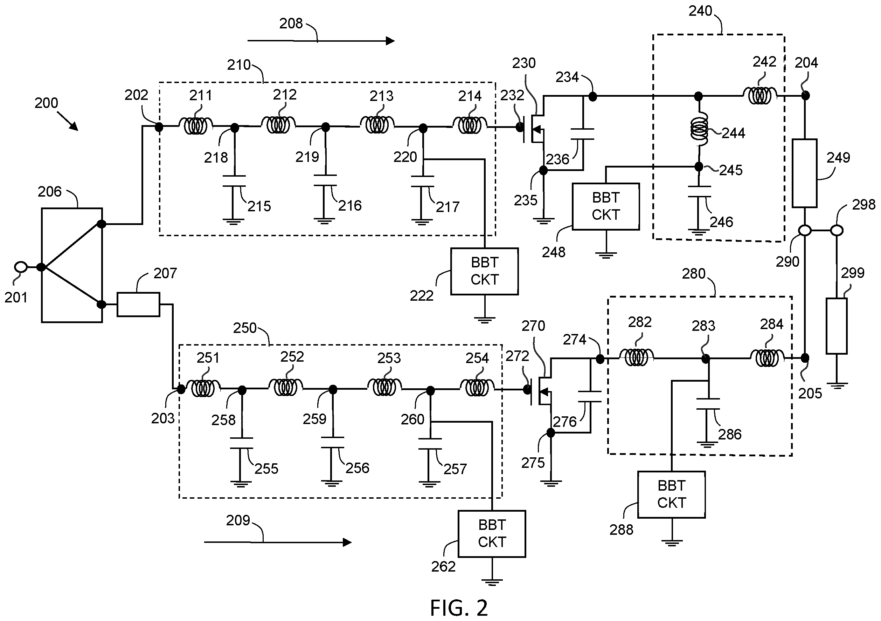

On the output side of the power amplifier 100, the output impedance matching circuit 139 and the output-side baseband termination circuit 148 (when included) are electrically coupled between the second terminal 134 of transistor 130 (e.g., the drain terminal of transistor 130) and the amplifier output 104. The output impedance matching circuit 139 is configured to match the output impedance of amplifier 100 with the input impedance of an external circuit or component (not shown) that may be coupled to amplifier output 104. As will be described later in conjunction with FIG. 2, the output impedance matching circuit 139 may have any of multiple circuit configurations (e.g., circuit 139 may have the configuration of circuit 230 or circuit 290, FIG. 2, in various embodiments).

According to one or more embodiments, another RF low-impedance point (also referred to as a "quasi RF cold point node") is present at a node (not shown in FIG. 1) within the output impedance matching circuit 139. Again, an RF low-impedance point represents a low impedance point in the circuit for RF signals. According to various embodiments, an additional output-side baseband termination circuit 148 is coupled between the RF low-impedance point within output impedance matching circuit 139 and the ground reference node. Again, baseband termination circuit 148 may function to further improve the LFR of amplifier 100 by presenting a low impedance at envelope frequencies and/or a high impedance at RF frequencies. Output-side baseband termination circuit 148 also may be considered to be "invisible" from an RF matching standpoint.

As will be described in more detail later in conjunction with FIGs 3-5, various embodiments of RF amplifier devices may include at least one input-side integrated passive device (IPD) assembly (e.g., IPD assemblies 321, 361, FIG. 3), and at least one output-side IPD assembly (e.g., IPD assemblies 347, 387, FIG. 3). Each IPD assembly may include a semiconductor substrate with one or more integrated passive components. The input-side IPD assembly(ies) (e.g., IPD assemblies 321, 361) include portions of the input impedance matching circuit 110 and the baseband termination circuit 122. In a particular embodiment, as will be described in detail below, each input-side IPD assembly may include shunt capacitors 115, 116, 117, and components of baseband termination circuit 122. Similarly, the output-side IPD assemblies (e.g., IPD assemblies 347, 387) include portions of the output impedance matching circuit 139 and the baseband termination circuit 148.

In other embodiments, some portions of the input and output impedance matching circuits 110, 139 and baseband termination circuits 122, 148 may be implemented as distinct/discrete components or as portions of other types of assemblies (e.g., a low-temperature co-fired ceramic (LTCC) device, a small PCB assembly, and so on). In still other embodiments, some portions of the input and/or output impedance matching circuits 110, 139 may be coupled to and/or integrated within the semiconductor die that includes transistor 130. The below, detailed description of embodiments that include IPD assemblies should not be taken to limit the inventive subject matter, and the term "passive device substrate" or "IPD substrate" means any type of structure that includes a passive device, including an IPD, a LTCC device, a transistor die, a PCB assembly, and so on.

In various embodiments, amplifier 100 also may include bias circuitry (not shown in FIG. 1). To provide a bias voltage to the gate terminal 132 and/or to the drain terminal 134 of the transistor 130, an external bias circuit (not shown) may be connected through the amplifier input 102, the amplifier output 104, and/or through additional package leads to the gate terminal 132 and/or to the drain terminal 134 of the transistor 130, and appropriate bias voltage(s) may be provided through the amplifier input 102, amplifier output 104, and/or additional leads.

The RF amplifier 100 of FIG. 1 may be utilized as a single-path amplifier, which receives an RF signal at amplifier input 102, amplifies the signal through transistor 130, and produces an amplified RF signal at amplifier output 104. Alternatively, multiple instances of the RF amplifier 100 may be utilized to provide a multiple-path amplifier, such as a Doherty power amplifier or another type of multi-path amplifier circuit.

For example, FIG. 2 is a simplified schematic diagram of a Doherty power amplifier 200 in which embodiments of RF power amplifier 100 may be implemented. Amplifier 200 includes an amplifier input terminal 201, an amplifier output terminal 298, a power divider 206 (or splitter), a carrier amplification path 208, a peaking amplification path 209, and a combining node 290. A load 299 may be coupled to the combining node 290 (e.g., through an impedance transformer, not shown) to receive an amplified RF signal from amplifier 200.

Power divider 206 is configured to divide the power of an input RF signal received at input terminal 201 into carrier and peaking portions of the input signal. The carrier input signal is provided to the carrier amplification path 208 at a first power divider output (not numbered), and the peaking input signal is provided to the peaking amplification path 209 at a second power divider output (not numbered). During operation in a full-power mode when both the carrier and peaking amplifiers 230, 270 are supplying current to the load 299, the power divider 206 divides the input signal power between the amplification paths 208, 209. For example, the power divider 206 may divide the power equally, such that roughly one half of the input signal power is provided to each path 208, 209 (e.g., for a symmetric Doherty amplifier configuration). Alternatively, the power divider 206 may divide the power unequally (e.g., for an asymmetric Doherty amplifier configuration).

Essentially, the power divider 206 divides an input RF signal supplied at the input terminal 201, and the divided signals are separately amplified along the carrier and peaking amplification paths 208, 209. The amplified signals are then combined in phase at the combining node 290. It is important that phase coherency between the carrier and peaking amplification paths 208, 209 is maintained across a frequency band of interest to ensure that the amplified carrier and peaking signals arrive in phase at the combining node 290, and thus to ensure proper Doherty amplifier operation.

The carrier input signal is amplified along the carrier amplification path 208 by one or more carrier amplifier transistors 230 between a carrier amplifier input terminal 202 and a carrier amplifier output terminal 204. Similarly, the peaking input signal is amplified along the peaking amplification path 209 by one or more peaking amplifier transistors 270 between a peaking amplifier input terminal 203 and a peaking amplifier output terminal 205. Although only one transistor 230, 270 is shown in each path 208, 209, each path 208, 209 actually may include more than one transistor (e.g., a series-coupled amplifier that includes a first transistor for a driver amplifier and a second transistor for a final-stage transistor). Accordingly, reference to a carrier amplifier transistor 230 or a peaking amplifier transistor 270 in the singular may be interpreted to mean a single carrier or peaking amplifier transistor 230, 270 or multiple carrier or peaking amplifier transistors 230, 270. In any event, transistor 230 includes a control terminal 232 (gate terminal) and two current conducting terminals 234, 235 (drain and source terminals), and transistor 270 includes a control terminal 272 (gate terminal) and two current conducting terminals 274, 275 (drain and source terminals). In FIG. 2, the drain-source capacitances of transistors 230, 270 are represented with capacitors 236 and 276 between the drain and source terminals 234, 235 or 274, 275 of each transistor 230, 270. Again, capacitors 236, 276 are not physical components, but instead model the drain-source capacitance of transistors 230, 270. According to an embodiment, transistors 230, 270 each may have a drain-source capacitance that is less than about 0.2 pF/mm to about 0.3 pF/mm (e.g., meaning 0.02 pF per watt (pF/W) to about 0.03 pF/W, assuming that the power density is about 10 W/mm, on average, although this value may depend on the class of operation, such as Class F versus Class F-1).

The one or more transistors 230, 270 in each of the carrier and peaking amplification paths 208, 209 may be implemented as one or more single-stage or multiple-stage power transistor integrated circuits (ICs) (or power transistor die) for amplifying an RF signal conducted through the transistor 230, 270. According to various embodiments, all amplifier stages or a final amplifier stage of either or both the carrier transistor(s) 230 and/or the peaking transistor(s) 270 may be implemented, for example, using a III-V field effect transistor (e.g., a HEMT), such as a GaN FET (or another type of III-V transistor, including a GaAs FET, a GaP FET, an InP FET, or an InSb FET). Where only one of the carrier transistor 230 or the peaking transistor 270 is implemented as one or more III-V FETs, the other amplifier may be implemented as one or more silicon-based FETs (e.g., an LDMOS FET), in some embodiments. In still other embodiments, both the carrier transistor 230 and the peaking transistor 270 may be implemented as one or more silicon-based FETs.

Although the carrier and peaking power transistor ICs may be of equal size (e.g., in a symmetric Doherty configuration), the carrier and peaking power transistor ICs may have unequal sizes, as well (e.g., in various asymmetric Doherty configurations). In an asymmetric Doherty configuration, the peaking power transistor IC(s) typically are larger than the carrier power transistor IC(s) by some multiplier. For example, the peaking power transistor IC(s) may be twice the size of the carrier power transistor IC(s) so that the peaking power transistor IC(s) have twice the current carrying capability of the carrier power transistor IC(s). Peaking-to-carrier amplifier IC size ratios other than a 2:1 ratio may be implemented, as well.

During operation of Doherty amplifier 200, the carrier transistor 230 is biased to operate in class AB mode, and the peaking transistor 270 is biased to operate in class C mode. At low power levels, where the power of the input signal at terminal 201 is lower than the turn-on threshold level of peaking transistor 270, the amplifier 200 operates in a low-power (or back-off) mode in which the carrier transistor 230 is the only amplifier supplying current to the load 299. When the power of the input signal exceeds a threshold level of the peaking transistor 270, the amplifier 200 operates in a high-power mode in which the carrier transistor 230 and the peaking transistor 270 both supply current to the load 299. At this point, the peaking transistor 270 provides active load modulation at combining node 290, allowing the current of the carrier transistor 230 to continue to increase linearly.

According to one or more embodiments, input and output impedance matching circuits 210, 240 may be implemented at the input and output of the carrier transistor 230. Similarly, input and output impedance matching circuits 250, 280 may be implemented at the input and output of the peaking transistor 270. In each case, the matching circuits 210, 240, 250, 280 may be used to incrementally increase the circuit impedance toward the load impedance and source impedance.

According to one or more embodiments, the input impedance matching circuits 210, 250 of the carrier and peaking amplification paths 208, 209 each have substantially the same circuit configuration as the input impedance matching circuit 110 discussed in conjunction with FIG. 1. For example, in one or more embodiments, each of the input impedance matching circuits 210, 250 has a "triple T-match" configuration. Further, the corresponding component value ranges for the inductive elements 211-214, 251-254 and capacitors 215-217, 255-257 may be the same as the component value ranges given for inductive elements 111-114 and capacitors 115-117 discussed in conjunction with FIG. 1.

Specifically, according to one or more embodiments, the carrier input impedance matching circuit 210 includes first, second, third, and fourth inductive elements 211, 212, 213, 214 with first, second, and third shunt capacitors 215, 216, 217 coupled to intermediate nodes 218, 219, 220 between the inductive elements 211-214. The embodiment of the carrier input impedance matching circuit 210 shown in FIG. 2 more specifically includes the first inductive element 211 coupled between the carrier amplifier input terminal 202 and the first intermediate node 218, the first shunt capacitor 215 coupled between the first intermediate node 218 and a ground reference node, the second inductive element 212 coupled between the first intermediate node 218 and the second intermediate node 219, the second shunt capacitor 216 coupled between the second intermediate node 219 and the ground reference node, the third inductive element 213 coupled between the second intermediate node 219 and the third intermediate node 220, the third capacitor 217 coupled between the third intermediate node 220 and the ground reference node, and the fourth inductive element 214 coupled between the third intermediate node 220 and the carrier transistor input terminal 232 (gate terminal). Shunt capacitor 217 may have a relatively-large capacitance (e.g., greater than 10 pF but less than 140 pF) to provide an acceptable RF low-impedance point at intermediate node 220 (e.g., intermediate node 220 may be a quasi RF cold point).

Similarly, the peaking input impedance matching circuit 250 includes first, second, third, and fourth inductive elements 251, 252, 253, 254 with first, second, and third shunt capacitors 255, 256, 257 coupled to intermediate nodes 258, 259, 260 between the inductive elements 251-254. The embodiment of the peaking input impedance matching circuit 250 shown in FIG. 2 more specifically includes the first inductive element 251 coupled between the peaking amplifier input terminal 203 and the first intermediate node 258, the first shunt capacitor 255 coupled between the first intermediate node 258 and a ground reference node, the second inductive element 252 coupled between the first intermediate node 258 and the second intermediate node 259, the second shunt capacitor 256 coupled between the second intermediate node 259 and the ground reference node, the third inductive element 253 coupled between the second intermediate node 259 and the third intermediate node 260, the third capacitor 257 coupled between the third intermediate node 260 and the ground reference node, and the fourth inductive element 254 coupled between the third intermediate node 260 and the peaking transistor input terminal 272 (gate terminal). Shunt capacitor 257 may have a relatively-large capacitance (e.g., greater than 10 pF but less than 140 pF) to provide an acceptable RF low-impedance point at intermediate node 260 (e.g., intermediate node 260 may be a quasi RF cold point).

It should be understood that, although FIG. 2 shows embodiments of input impedance matching circuits 210, 250 with three T-match circuits (a "triple T-match" configuration), one or more additional components may be included in the input impedance matching circuits 210, 250, in other embodiments (e.g., additional inductive elements, capacitors, and/or T-match circuits). Accordingly, embodiments of input impedance matching circuits 210, 250 are not limited to having only three T-match circuits.

On the output side, output impedance matching circuits 240, 280 are coupled between the output terminals 234, 274 (drain terminals) of the carrier and peaking transistors 230, 270 and the carrier and peaking amplifier output terminals 204, 205. According to one or more embodiments, the output impedance matching circuits 240, 280 have different circuit topologies, as will be described below in detail. In other embodiments, the output impedance matching circuits 240, 280 could have the same circuit topology (e.g., either of the topologies shown for circuits 240, 280 in FIG. 2).

As illustrated in FIG. 2, the carrier output impedance matching circuit 240 includes a first inductive element 242 coupled between the carrier output terminal 234 (drain terminal) and the carrier amplifier output terminal 204. In addition, the carrier output impedance matching circuit 240 includes a second inductive element 244 and a shunt capacitor 246 coupled in series between the carrier output terminal 234 and the ground reference node, with an intermediate node 245 between the inductive element 244 and capacitor 246. According to one or more embodiments, each of inductive elements 242, 244 may have an inductance value in a range between about 50 pH to about 750 pH, and shunt capacitor 246 may have a relatively-large capacitance (e.g., greater than 10 pF but less than 280 pF) to provide an acceptable RF low-impedance point at intermediate node 245. In some embodiments, inductive element 244 enables intermediate node 245 to be a substantially perfect "RF cold point" (i.e., a node at which substantially zero voltage at RF frequencies may be present during operation).

As mentioned above, the peaking output impedance matching circuit 280 may have a different circuit topology from the carrier output impedance matching circuit 240. As illustrated in FIG. 2, the peaking output impedance matching circuit 280 has a "T-match" topology that includes first and second inductive elements 282, 284 coupled in series between the peaking output terminal 274 (drain terminal) and the peaking amplifier output terminal 205, with an intermediate node 283 between the inductive elements 282, 284. In addition, the peaking output impedance matching circuit 280 includes a shunt capacitor 286 coupled between the intermediate node 283 and the ground reference node. According to one or more embodiments, each of inductive elements 282, 284 may have an inductance value in a range between about 50 pH to about 750 pH, and shunt capacitor 286 may have a relatively-large capacitance (e.g., greater than 10 pF but less than 140 pF) to provide an acceptable RF low-impedance point at intermediate node 283. In some embodiments, intermediate node 283 is a quasi RF cold point.

In one or more embodiments, baseband termination circuits 222, 248, 262, 288 may be coupled to some or all of the intermediate nodes 220, 245, 260, 283, respectively. As mentioned above, each of nodes 220, 245, 260, 283 may be "perfect" RF cold point nodes or "quasi" RF cold point nodes, and thus these nodes are good locations for coupling the baseband termination circuits 222, 248, 262, 288. The baseband termination circuits 222, 248, 262, 288 may have any of a number of different circuit configurations, in various embodiments. Further, the circuit topologies of the baseband termination circuits 222, 248, 262, 288 may be the same as each other or may be different from each other. As an example, referring again briefly to FIG. 4 (which will be discussed in detail later), some or all of the baseband termination circuits 222, 248, 262, 288 may have a similar/identical topology as baseband termination circuit 322 (FIG. 4), which includes an envelope inductor 423, an envelope resistor 424, and an envelope capacitor 426, coupled in series between an intermediate node 420 (e.g., corresponding to node 220, FIG. 2) and a ground reference node (e.g., conductive layer 565, FIG. 5). In some embodiments, a bypass capacitor 425 may be electrically coupled across one or more of the envelope inductor 423 and the envelope resistor 424.

Doherty amplifier 200 has a "non-inverted" load network configuration. In the non-inverted configuration, the input circuit is configured so that an input signal supplied to the peaking transistor 270 is delayed by 90 degrees with respect to the input signal supplied to the carrier transistor 230 at the center frequency of operation, *fo*, of the amplifier 200. To ensure that the carrier and peaking input RF signals arrive at the carrier and peaking transistors 230, 270 with about 90 degrees of phase difference, as is fundamental to proper Doherty amplifier operation, phase delay element 207 applies about 90 degrees of phase delay to the peaking input signal. For example, phase delay element 207 may include a quarter wave transmission line, or another suitable type of delay element with an electrical length of about 90 degrees. In other embodiments, the 90 degree phase delay may be imparted by the power splitter 206.

The 90 degree phase delay applied by the phase delay element 207 at the input of transistor 270 compensates for about a 90 degree phase delay applied to the amplified carrier signal between the output terminal 234 of the of carrier transistor 230 and the combining node 290. The output-side phase delay is achieved through an additional delay element 249, which also implements an impedance inversion (thus, element 249 may be referred to herein as an impedance inversion and phase delay element). Alternate embodiments of Doherty amplifiers may have an "inverted" load network configuration. In such a configuration, the input circuit is configured so that an input signal supplied to the carrier transistor 230 is delayed by about 90 degrees with respect to the input signal supplied to the peaking transistor 270 at the center frequency of operation, *fo*, of the amplifier 200, and the output circuit is configured to apply about a 90 degree phase delay (and impedance inversion) to the signal between the output of peaking transistor 270 and the combining node 290.

Transistors 230 and 270 and all or portions of matching circuits 210, 240, 250, 280 and baseband termination circuits 222, 248, 262, 288 may be implemented in discrete, packaged power amplifier devices. In such devices, input and output leads are coupled to a package body, and each transistor 230, 270 may include a single-stage or multi-stage power transistor implemented within the package body. The input and output matching circuits 210, 240, 250, 280 and the baseband termination circuits 222, 248, 262, 288 may be implemented as additional components within the package body.

For example, FIG. 3 is a top view of an embodiment of a packaged RF amplifier device 300 that embodies two parallel instances of the amplifier 100 of FIG. 1, where a first instance corresponds to a portion of a carrier amplification path 394 (e.g., path 208, FIG. 2) and a second instance corresponds to a portion of a peaking amplification path 309 (e.g., path 209, FIG. 2) of a Doherty power amplifier (e.g., amplifier 200, FIG. 2). For enhanced understanding, FIG. 3 should be viewed simultaneously with FIGs 4 and 5, where FIG. 4 illustrates an enlarged portion 400 (surrounded by a dash-dotted box) of the device 300 of FIG. 3 that includes an interior end of the input lead 302, IPD assembly 321, and part of the transistor die 330 along amplification path 308. FIG. 5 is a cross-sectional, side view of the portion 400 of device 300 in FIG. 4 along line 5-5. It should be understood that, although portion 400 of device 300 depicts details of the input circuitry of amplification path 308 in detail, the input circuitry of amplification path 309 may be substantially the same as the input circuitry along amplification path 308. More specifically, the input circuitry for both the carrier and peaking amplification paths may be implemented as shown in FIGs 4 and 5, and as described in detail below.

Device 300 includes a flange 393 (or "device substrate"), in an embodiment, which includes a rigid electrically-conductive substrate with a thickness that is sufficient to provide structural support for various electrical components and elements of device 300. In addition, flange 393 may function as a heat sink for transistor dies 330, 370 and other devices mounted on flange 393. Flange 393 has top and bottom surfaces (only a central portion of the top surface is visible in FIG. 3), and a substantially-rectangular perimeter that corresponds to the perimeter of the device 300.

Flange 393 is formed from an electrically conductive material, and may be used to provide a ground reference node for the device 300. For example, various components and elements may have terminals that are electrically coupled to flange 393, and flange 393 may be electrically coupled to a system ground when the device 300 is incorporated into a larger electrical system. At least the top surface of flange 393 is formed from a layer of conductive material, and possibly all of flange 393 is formed from bulk conductive material.

An isolation structure 394 is attached to the top surface of flange 393, in an embodiment. Isolation structure 394, which is formed from a rigid, electrically insulating material, provides electrical isolation between conductive features of the device (e.g., between leads 302-305 and flange 393). Isolation structure 394 has a frame shape, in an embodiment, which includes a substantially enclosed, four-sided structure with a central opening. Isolation structure 394 may have a substantially rectangular shape, as shown in FIG. 3, or isolation structure 394 may have another shape (e.g., annular ring, oval, and so on).

A portion of the top surface of flange 393 that is exposed through the opening in isolation structure 394 is referred to herein as the "active area" of device 300. Transistor dies 330, 370 are positioned within the active device area of device 300, along with integrated passive device (IPD) assemblies 321, 347, 361, 387, which will be described in more detail later. For example, the transistor dies 330, 370 and IPD assemblies 321, 347, 361, 387 may be coupled to the top surface of flange 393 using conductive epoxy, solder, solder bumps, sintering, and/or eutectic bonds.

Device 300 houses two amplification paths (indicated with arrows 308, 309), where each amplification path 308, 309 represents a physical implementation of amplifier 100 (FIG. 1) or a physical implementation of the carrier or peaking amplifiers between input 202 or 203 and output 204 or 205 (FIG. 2). More specifically, amplification path 308 represents a physical implementation of the carrier amplifier between input 202 and output 204 (FIG. 2), and amplification path 309 represents a physical implementation of the peaking amplifier between input 203 and output 205 (FIG. 2). Accordingly, when incorporated into a Doherty amplifier (e.g., Doherty amplifier 200, FIG. 2), amplification path 308 may correspond to a carrier amplification path (e.g., carrier amplification path 208, FIG. 2), and amplification path 309 may correspond to a peaking amplification path (e.g., peaking amplification path 209, FIG. 2).

Each path 320, 321 includes an input package lead 302, 303 (e.g., amplifier inputs 102, 202, 203, FIGs 1, 2), an output package lead 304, 305 (e.g., amplifier outputs 104, 204, 205, FIGs 1, 2), one or more transistor dies 330, 370 (e.g., including integrated transistors 130, 230, 270, FIGs 1, 2), an input impedance matching circuit 310, 350 (e.g., input impedance matching circuits 110, 210, 250, FIGs 1, 2), an output impedance matching circuit 340, 380 (e.g., output impedance matching circuits 139, 240, 280, FIGs 1, 2), an input-side baseband termination circuit 322, 362 (e.g., baseband termination circuits 122, 222, 262, FIGs 1, 2), and an output-side baseband termination circuit 348, 388 (e.g., baseband termination circuits 148, 248, 288, FIGs 1, 2). As will be discussed below, each path also may include additional "out-of-package" baseband termination circuits 396, 397, according to one or more embodiments.

The input and output leads 302-305 are mounted on a top surface of the isolation structure 394 on opposite sides of the central opening, and thus the input and output leads 302-305 are elevated above the top surface of the flange 393, and are electrically isolated from the flange 393. Generally, the input and output leads 302-305 are oriented to allow for attachment of wirebonds between interior ends of the input and output leads 302-305 and components and elements mounted to the flange 393 within the central opening of isolation structure 394.

Each transistor die 330, 370 is mounted on the exposed surface of flange 393. Referring also briefly to FIG. 5, each transistor die 330, 370 includes a base semiconductor substrate 567 and a build-up structure 568 on an upper surface of the base semiconductor substrate 567. In addition, each transistor die 330, 370 may include a conductive layer 569 on a lower surface of the base semiconductor substrate 567, which may be directly connected to the flange 383, and which serves as a ground reference node for the transistor die 330, 370.

Each transistor die 330, 370 also includes an integrated transistor (e.g., transistor 530, FIG. 5, which corresponds to transistor 230, FIG. 2). Each integrated transistor has a control terminal (e.g., a gate or input terminal 232, 272, FIG. 2) and two current conducting terminals (e.g., a drain and a source, or first current conducting terminals 234, 274 and second current conducting terminals 235, 275, FIG. 2). A control terminal of a FET within each transistor die 330, 370 is coupled through an input impedance matching circuit 310, 350 to an interior end of an input lead 302, 303. In addition, one current conducting terminal (e.g., the drain) of a FET within each transistor die 330, 370 is coupled through an output impedance matching circuit 340, 380 to an interior end of an output lead 304, 305. The other current conducting terminal (e.g., the source) of a FET within each transistor die 330, 370 is electrically coupled through the die 330, 370 to the conductive layer 569 and to the flange 393 (e.g., to ground), in an embodiment.

As discussed previously, each integrated transistor (e.g., transistor 530) may include a III-V field effect transistor (e.g., a HEMT), such as a GaN FET (or another type of III-V transistor, including a GaAs FET, a GaP FET, an InP FET, or an InSb FET), or alternatively, each integrated transistor may include a silicon-based transistor. More specifically, each transistor (e.g., transistor 530) includes a plurality of doped and not-intentionally-doped semiconductor regions in the base semiconductor substrate 567 (e.g., a GaN substrate, a GaN-on-silicon substrate, a GaN-on-silicon carbide substrate, silicon, silicon carbide, and so on). In addition, each transistor includes a plurality of conductive structures (e.g., gate structures) and contacts (e.g., drain and source contacts) formed in the build-up structure 568 over the semiconductor regions. As indicated in FIG. 5, the integrated transistor 530 is electrically coupled through the build-up structure 568 to bond pads (e.g., an input/gate bond pad 432, an output/drain bond pad (not shown), and bond pads (not shown) for receiving bias voltages) at the upper surface of the transistor die 330, 370.

Each input impedance matching circuit 310, 350 (e.g., circuits 110, 210, 250, FIGs 1, 2) is coupled between an input lead 302, 303 (e.g., input 102, 202, 203, FIGs 1, 2) and a control terminal (e.g., a gate terminal 132, 232, 272, FIGs 1, 2) of a transistor (e.g., transistor 130, 230, 270, 530, FIGs 1, 2, 5) within a transistor die 330, 370. According to one or more embodiments, each input impedance matching circuit 310, 350 includes a plurality of passive devices (e.g., capacitors 415-417, FIGs 4, 5) integrally formed within (and/or coupled to) an IPD assembly 321, 361, and a plurality of inductive elements (e.g., wirebonds 411-414, FIGs 4, 5) coupled between the input leads 302, 303 and the input terminals (e.g., terminal 432, FIGs 4, 5, corresponding to terminal 132, 232, 272, FIGs 1, 2) of the transistor dies 330, 370. Each IPD assembly 321, 361 is mounted on the exposed surface of flange 393 between an input lead 302, 303 and a transistor die 330, 370.

FIGs 4 and 5 include detailed depictions of the carrier input impedance matching circuit 310 and the carrier input-side baseband termination circuit 322, and details of circuits 310, 322 will be described in detail below. It should be understood that the peaking input impedance matching circuit 350 and the peaking input-side baseband termination circuit 362 may be substantially identical to the carrier input impedance matching circuit 310 and the carrier input-side baseband termination circuit 322. Accordingly, details described below with regard to the carrier input impedance matching circuit 310, the carrier input-side baseband termination circuit 322, and the IPD assembly 321 apply also to the peaking input impedance matching circuit 350, the peaking input-side baseband termination circuit 362, and IPD assembly 361.

As best seen in FIG. 5, IPD assembly 321 includes a base semiconductor substrate 563 and a build-up structure 564 on an upper surface of the base semiconductor substrate 563. The build-up structure 564 includes a plurality of alternating dielectric and patterned conductive layers, where portions of the patterned conductive layers are electrically connected using conductive vias. In addition, IPD assembly 321 also may include a conductive layer 565 on a lower surface of the base semiconductor substrate 563, which may be directly connected to the flange 383, and which serves as a ground reference node for the IPD assembly 321. For example, the base semiconductor substrate 563 may include a silicon substrate, a silicon carbide substrate, or another suitable type of semiconductor substrate.

Various electrical components of the input impedance matching circuit 310 and the baseband termination circuit 322 are integrally formed within and/or connected to the IPD assembly 321. As will be described in more detail below, these electrical components may be electrically connected to conductive bond pads (e.g., bond pads 418, 419, 420) at the top surface of the IPD assembly 321, and also may be electrically connected to the conductive flange 393 (e.g., to the ground reference node) using through substrate vias to the conductive layer 565 on the lower surface of the IPD assembly 321. The bond pads 418-420 correspond to intermediate nodes (e.g., nodes 118-120, 218-220, FIGs 1, 2) in the input impedance matching circuit 310.

According to one or more embodiments, the input-side IPD assembly 321 more specifically includes first, second, and third shunt capacitors 415, 416, 417 (e.g., shunt capacitors 115-117, 215-217, FIGs 1, 2) of the input impedance matching circuit 310 (e.g., circuit 110, 210, FIGs 1, 2). In other words, each of the shunt capacitors 415-417 of the input impedance matching circuit 310 may be implemented as a capacitor (or a set of parallel-coupled capacitors) that is integrally formed with the IPD assembly 321. For example, each of the shunt capacitors 415-417 may be implemented as one or more integrated metal-insulator-metal (MIM) capacitors. As such, each shunt capacitor 415-417 includes first and second conductive electrodes (formed from patterned portions of the conductive layers of build-up structure 564) that are aligned with each other and electrically separated by dielectric material of the build-up structure 564. A first electrode (or terminal) of each shunt capacitor 415-417 is electrically coupled to a conductive bond pad 418, 419, or 420 (corresponding to the first, second, and third intermediate nodes 118, 119, 120, 218, 219, 220, FIGs 1, 2), and a second electrode (or terminal) of each shunt capacitor 415-417 is electrically coupled to the conductive flange 393 (e.g., using conductive through substrate vias that extend through the IPD base semiconductor substrate 563), according to one or more embodiments. In a more specific embodiment, the first electrode of each shunt capacitor 415-417 is "directly connected" to a respective bond pad 418-420, where "directly connected" means electrically connected, possibly with one or more conductive traces and/or conductive vias, but without intervening circuit elements (i.e., circuit elements that have more than a trace inductance, where a "trace inductance" is an inductance less than about 100 pH). Because the shunt capacitors 415-417 and the bond pads 418-420 are "directly connected," and the bond pads 418-420 also have only a trace inductance, in an embodiment, the inductive elements 411-414 (wirebond arrays) and the shunt capacitors 415-417 also may be considered to be "directly connected." In one or more alternate embodiments, one or more of the shunt capacitors 415-417 may be implemented using a discrete capacitor coupled to the upper surface of the IPD assembly 321. According to an embodiment, each shunt capacitor 415-417 may have a capacitance value in a range between about 2 pF to about 140 pF, although the capacitance values may be lower or higher, as well.

In the embodiment illustrated in FIGs 3-5, all of the shunt capacitors 415-417 are implemented in a single IPD assembly (i.e., IPD assembly 321). In alternate embodiments, the shunt capacitors 415-417 could be implemented in multiple IPD assemblies, instead. For example, referring to FIG. 5, dashed vertical scribe lines 566 indicate where IPD 321 may be divided into two or three separate IPDs, where each IPD includes only one or two capacitors 415-417. In such embodiments, the multiple IPDs could be coupled to flange 393 next to each other.

In addition to the shunt capacitors 415-417, the input impedance matching circuit 310 includes first, second, third, and fourth inductive elements (e.g., inductive elements 411, 412, 413, 414) coupled in series between the input lead 302 and the input terminal (e.g., input terminal 432) of the transistor die 330. According to an embodiment, each of the inductive elements 411-414 may have an inductance value in a range between about 30 pH to about 750 pH, although their inductance values may be lower or higher, as well.

According to one or more embodiments, each of the inductive elements 411-414 may include a plurality of wirebonds (a "wirebond array"). Specifically, the first inductive element 411 includes a first plurality of wirebonds with first ends coupled to the input lead 302, and second ends coupled to the first bond pad 418 (e.g., the first intermediate node 118, 218, FIGs 1, 2). The second inductive element 412 includes a second plurality of wirebonds with first ends coupled to the first bond pad 418 and second ends coupled to the second bond pad 419 (e.g., the second intermediate node 119, 219, FIGs 1, 2). The third inductive element 413 includes a third plurality of wirebonds with first ends coupled to the second bond pad 419 and second ends coupled to the third bond pad 420 (e.g., the third intermediate node 120, 220, FIGs 1, 2). Finally, the fourth inductive element 414 includes a fourth plurality of wirebonds with first ends coupled to the third bond pad 420 and second ends coupled to the input terminal 432 (e.g., input terminal 132, 232, FIGs 1, 2) of transistor die 330.

In the embodiment illustrated in FIGs 3-5, the second and third inductive elements 412, 413 each include a wirebond array. According to one or more alternate embodiments, either or both of the second and third inductive elements 412, 413 alternatively could be implemented as an inductance that is integrated within the IPD assembly 312 (e.g., an integrated spiral inductor), or as a surface mounted inductor that is coupled to the upper surface of the IPD assembly 312.

Either way, as discussed above, the configuration of the input impedance matching networks 310, 350 corresponds to a triple T-match configuration. In addition, the conductive bond pad 420 may correspond to an RF low-impedance point node, or a "quasi RF cold point node" (e.g., node 120, 220, FIGs 1, 2), in an embodiment. According to an embodiment, baseband termination circuit 322 (e.g., circuits 122, 222, FIGs 1, 2) is electrically coupled to bond pad 420 (i.e., to the quasi RF cold point node).

In the embodiment of FIGs 3-5, the components of baseband termination circuit 322 included in IPD assembly 321 more specifically include an envelope resistor 423, an envelope inductor 424, and an envelope capacitor 426 coupled in series between bond pad 420 and the conductive layer 565 (i.e., the IPD ground reference node). Further, the embodiment of the baseband termination circuit 322 included in IPD assembly 321 also includes an optional bypass capacitor 425 coupled in parallel with the envelope inductor 424. In the embodiment of FIGs 3-6, two instances of the parallel combination of envelope inductor 424 and bypass capacitor 425 are implemented on opposite sides of the IPD assembly 321. More specifically, the parallel combinations of envelope inductor 424 and bypass capacitor 425 are connected in parallel between envelope resistor 423 and envelope capacitor 426, in the illustrated embodiment. In an alternate embodiment, the baseband termination circuit 322 may include only one instance of the combination of envelope inductor 424 and bypass capacitor 425, or more than two instances of the combination of envelope inductor 424 and bypass capacitor 425.

Either way, the envelope resistor 423, envelope inductance 424, and envelope capacitor 426 may be integrally formed as part of the IPD assembly 321. For example, the envelope resistor 423 may be a polysilicon resistor formed from a layer of polysilicon on or within build-up structure 564, and electrically coupled between bond pad 420 (e.g., node 120, 220, FIGs 1, 2) and the parallel combination(s) of envelope inductor 424 and bypass capacitor 425. In other alternate embodiments, the envelope resistor 423 may be formed from tungsten silicide or another material, may be a thick or thin film resistor, or may be a discrete component coupled to a top surface of IPD assembly 321.

Each envelope inductor 424 may be provided by a patterned conductor formed from portion(s) of one or more conductive layers of the build-up structure 564, where a first end of the conductor is electrically coupled to envelope resistor 423, and a second end of the conductor is electrically coupled to a first terminal of envelope capacitor 426. In alternate embodiments, each envelope inductor 424 may be implemented as a plurality of wirebonds, or as a spiral inductor (e.g., on or proximate to the top surface of IPD assembly 321), or as a discrete inductor coupled to a top surface of IPD assembly 321.

As mentioned above, a bypass capacitor 425 may be coupled in parallel with each envelope inductor 424, in an embodiment. The bypass capacitors 425 may be, for example, a discrete capacitor that is connected (e.g., using solder, a conductive epoxy, or other means) to a top surface of IPD assembly 321. More specifically, a first terminal of each bypass capacitor 425 may be electrically coupled to the envelope resistor 423 and to a first terminal of the envelope inductor 424, and a second terminal of the bypass capacitor 425 may be connected to a second terminal of the envelope inductor 424 and to a first terminal of the envelope capacitor 426.

The envelope capacitor 426 is electrically coupled between a ground reference node (e.g., conductive layer 565 at the bottom surface of the IPD assembly 321) and the parallel combination of envelope inductor 424 and bypass capacitor 425. Capacitor 426 may be a MIM capacitor that is integrally formed in the build-up structure 564 entirely above the semiconductor substrate 563, or capacitor 426 may have portions that extend into the semiconductor substrate 563 or are otherwise coupled to, or in contact with, the semiconductor substrate 563. According to an embodiment, the capacitor 426 may be formed from a first electrode, a second electrode, and a dielectric material between the first and second electrodes. Alternatively, the envelope capacitor 426 may be, for example, a discrete capacitor that is connected (e.g., using solder, a conductive epoxy, or other means) to an upper surface of the IPD assembly 321. Although particular two-plate capacitor structures are shown in FIG. 5 for capacitors 415-417 and 426, a variety of other capacitor structures alternatively may be utilized, as would be understood by one of skill in the art based on the description herein.

According to one or more embodiments, an additional "out-of-package" baseband termination circuit 396 also may be coupled to the input circuit along each amplification path 308, 309. For example, referring to FIG. 4, an "out-of-package" baseband termination circuit 396 may be coupled to the bond pad 320 (e.g., to the quasi RF cold point corresponding to intermediate node 120, 220, FIGs 1, 2). The additional out-of-package baseband termination circuit 396 may include a first inductance provided by a set of wirebonds (e.g., wirebonds 496, FIG. 4) between the bond pad 320 on IPD assembly 321 and an extra package lead (not numbered), plus a second inductance provided by the extra package lead, plus a shunt capacitance provided by a discrete capacitor (not numbered) with a first terminal connected to a distal end of the extra package lead, and a second terminal coupled to a ground reference node of a system substrate to which the device 300 and the discrete capacitor are coupled.

Referring again to FIG. 3, the output impedance matching circuits 340, 380 (e.g., circuits 240, 280, FIG. 2) are coupled between the output terminals (e.g., drain terminals 234, 274, FIG. 2) of the carrier and peaking transistors within the transistor dies 330, 370 and the carrier and peaking amplifier output leads 304, 305. According to various embodiments, the output impedance matching circuits 340, 380 may have different circuit topologies, or they may have the same circuit topology.

For example, as described in conjunction with FIG. 2, the carrier output impedance matching circuit 340 may include a first inductive element (e.g., a set of wirebonds corresponding to element 242, FIG. 2) coupled between the carrier output terminal (e.g., drain terminal 234) and the carrier amplifier output terminal 304. In addition, the carrier output impedance matching circuit 340 may include a second inductive element (e.g., another set of wirebonds corresponding to element 244, FIG. 2) and a shunt capacitor (e.g., capacitor 246, FIG. 2) coupled in series between the carrier output terminal and the ground reference node (e.g., flange 393), with an intermediate node (e.g., RF cold point node 245, FIG. 2) between the inductive element and capacitor. According to one or more embodiments, the shunt capacitor may be integrally formed in IPD assembly 347, and the intermediate node may correspond to a bond pad (not numbered) on a top surface of IPD assembly 347.

In one or more embodiments, an output-side baseband termination circuit (e.g., circuit 248, FIG. 2) may be coupled to the intermediate node, and may include a plurality of components integrated within IPD assembly 347 (e.g., a series-coupled resistor, inductor, and shunt capacitor). According to one or more embodiments, an additional "out-of-package" baseband termination circuit 397 also may be coupled to the intermediate node. The additional out-of-package baseband termination circuit 397 may include a first inductance provided by a set of wirebonds (not numbered) between the intermediate node (e.g., bond pad) on IPD assembly 347 and an extra package lead (not numbered), plus a second inductance provided by the extra package lead, plus a shunt capacitance provided by a discrete capacitor (not numbered) with a first terminal connected to a distal end of the extra package lead, and a second terminal coupled to a ground reference node of a system substrate to which the device 300 and the discrete capacitor are coupled.

As mentioned above, the peaking output impedance matching circuit 380 may have a different circuit topology from the carrier output impedance matching circuit 340. For example, as described in conjunction with FIG. 2, the peaking output impedance matching circuit 380 may include first and second inductive elements (e.g., two sets of wirebonds corresponding to elements 282, 284, FIG. 2) coupled in series between the peaking output terminal (drain terminal 274) and the peaking amplifier output terminal 305, with an intermediate node (e.g., quasi RF cold point node 283, FIG. 2) between the inductive elements. In addition, the peaking output impedance matching circuit 380 may include a shunt capacitor (e.g., capacitor 286, FIG. 2) coupled between the intermediate node and the ground reference node. According to one or more embodiments, the shunt capacitor may be integrally formed in IPD assembly 387, and the intermediate node may correspond to a bond pad (not numbered) on a top surface of IPD assembly 387.

In one or more embodiments, an output-side baseband termination circuit (e.g., circuit 288, FIG. 2) may be coupled to the intermediate node, and may include a plurality of components integrated within IPD assembly 387 (e.g., a series-coupled resistor, inductor, and shunt capacitor). According to one or more embodiments, another additional out-of-package baseband termination circuit 397 also may be coupled to the intermediate node. The additional out-of-package baseband termination circuit 397 may include a first inductance provided by a set of wirebonds (not numbered) between the intermediate node (e.g., bond pad) on IPD assembly 387 and an extra package lead (not numbered), plus a second inductance provided by the extra package lead, plus a shunt capacitance provided by another discrete capacitor (not numbered) with a first terminal connected to a distal end of the extra package lead, and a second terminal coupled to a ground reference node of a system substrate to which the device 300 and the discrete capacitor are coupled.

In the example of FIG. 3, device 300 includes two transistor dies 330, 370 that essentially function in parallel, although another semiconductor device may include a single transistor die or more than two transistor dies, as well. In addition, device 300 includes two input-side IPD assemblies 321, 361 and two output-side IPD assemblies 347, 387, which also essentially function in parallel. It is to be understood that more or fewer of IPD assemblies 321, 347, 361, 387 may be implemented, as well. For example, referring to FIG. 5, dashed vertical scribe lines 566 indicate where IPD 321 may be divided into two or three separate IPDs, which may be coupled to flange 393 next to each other.

According to an embodiment, device 300 is incorporated in an air cavity package, in which transistor dies 330, 370, the IPD assemblies 321, 347, 361, 387, and various other components are located within an enclosed air cavity. Basically, the air cavity is bounded by flange 393, isolation structure 394, and a cap (not shown) overlying and in contact with the isolation structure 394 and leads 302-305. In FIG. 3, an example perimeter of the cap is indicated by dashed box 395. In other embodiments, the components of device 300 may be incorporated into an overmolded package (i.e., a package in which the electrical components within the active device area are encapsulated with a non-conductive molding compound, and in which portions of the leads 302-305 also may be encompassed by the molding compound). In an overmolded package, isolation structure 394 may be excluded.

FIGs 3-5 illustrate embodiments of RF amplifier devices that include input and output leads coupled to a substrate (e.g., with intervening electrical isolation), and a transistor die also coupled to the substrate between the input and output leads. Such RF amplifier devices may be particularly well suited for high-power amplification. Those of skill in the art would understand, based on the description herein, that the various embodiments may be implemented using different forms of packaging or construction, as well. For example, one or multiple amplification paths that include embodiments of the inventive subject matter could be coupled to a substrate such as a PCB, a no-leads type of package (e.g., a quad-flat no-leads (QFN) package), or another type of package. In such embodiments, inputs and outputs of the amplification path(s) could be implemented using conductive lands or other input/output (I/O) structures. Such implementations may be particularly suitable for lower-power amplification systems, for example, including a relatively low-power Doherty amplifier in which carrier and peaking amplification paths (including bare transistor dies, IPDs, bias circuits, and so on), a power divider, delay and impedance inversion elements, a combiner, and other components may be coupled to the substrate. It should be understood that implementations of the inventive subject matter are not limited to the illustrated embodiments.

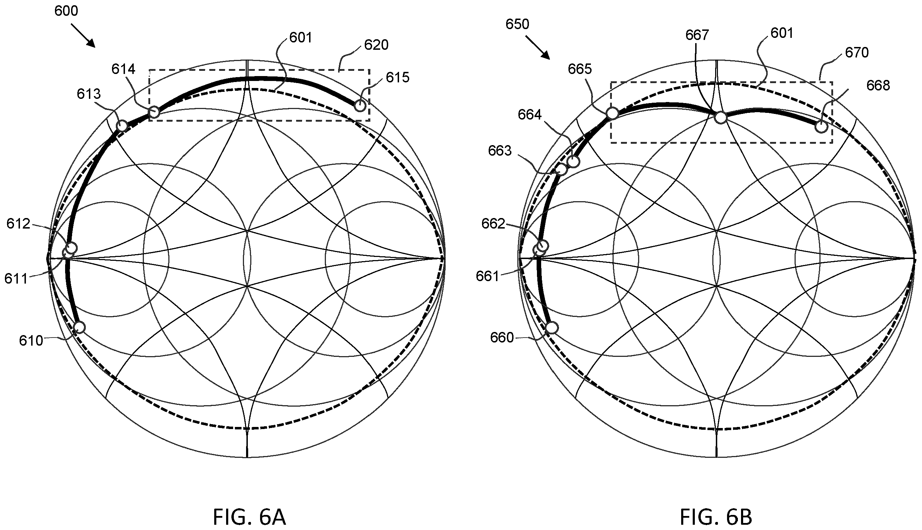

FIGs 6A and 6B are Smith charts 600, 650 comparing fundamental input impedance transformations from Zsource_extrinsic to the lead plane of power amplifiers with and without embodiments of input impedance matching circuits described herein. More specifically, Smith chart 600 depicts the impedance transformation between the impedance at the gate of a transistor (Zsource_extrinsic) and the impedance at the lead plane for an input impedance matching circuit with a double input T-match circuit that is coupled between an input lead and the transistor gate. Similarly, Smith chart 650 depicts the impedance transformation between the impedance at the gate of a transistor (Zsource_extrinsic) and the impedance at the lead plane for an embodiment of an input impedance matching circuit with a triple input T-match circuit (e.g., circuits 110, 210, 250, 310, 350, FIGs 1-3) that is coupled between an input lead (e.g., input 102, 202, 203, 302, 303, FIGs 1-4) and the transistor gate (e.g., gate 132, 232, 272, 432, FIGs 1, 2, 4).

In both Smith charts 600, 650, the dashed arcs represent a quality circle 601 for the transistor, which corresponds to the gate impedance (Zsource_extrinsic) and depends at least in part on the transistor periphery, which defines the parasitic gate-source capacitance. In order to achieve low losses and high gain, it is desirable to design an input impedance matching circuit that implements an impedance transformation that stays within the quality circle 601. As will be explained below, the impedance transformation represented in Smith chart 600 for a double input T-match circuit transitions outside of the quality circle 601, while the impedance transformation represented in Smith chart 650 for a triple input T-match circuit stays within the quality circle 601. Accordingly, a comparison of Smith charts 600 and 650 indicate that an amplifier that includes an embodiment of a triple input T-match circuit may be characterized by lower losses and higher gain than an amplifier that includes a double input T-match circuit.

Referring first to Smith chart 600, a double input T-match circuit may include first, second, and third inductances coupled in series between a transistor gate and an input lead, with a first intermediate node and a first shunt capacitor between the first and second inductances, and a second intermediate node and a second shunt capacitor between the second and third inductances. Point 610 corresponds to the extrinsic impedance (Zsource_extrinsic) at the transistor gate, and the first series inductance results in a first impedance transformation to point 611. The first shunt capacitor results in a second impedance transformation from point 611 to point 612. The second series inductance results in a third impedance transformation from point 612 to point 613. The second shunt capacitor results in a fourth impedance transformation from point 613 to point 614. Finally, the third series inductance results in a fifth impedance transformation from point 614 to point 615, where point 615 corresponds to the impedance at the lead plane.

As indicated in dashed box 620, the characteristics of the double input T-match circuit causes the impedance trajectory to transition outside of the quality circle 601. This is due at least in part to the need for a relatively high inductance for the third series inductance (e.g., a relatively long wirebond between the input lead and the second intermediate node).

Referring next to Smith chart 650, a triple input T-match circuit (e.g., any of circuits 110, 210, 250, 310, FIGs 1, 2, 4) may include first, second, third, and fourth inductances (e.g., inductances 114, 113, 112, 111 or inductances 214, 213, 212, 211, or wirebonds 414, 413, 412, 411, FIGs 1, 2, 4) coupled in series between a transistor gate (e.g., gate 132, 232, 432, FIGs 1, 2, 4) and an input lead (e.g., input 102, 202, 203, 302, 303, FIGs 1-4), with a first intermediate node (e.g., node 120, 220 or bond pad 420) and a first shunt capacitor (e.g., capacitor 117, 217, 417) between the first and second inductances, a second intermediate node (e.g., node 119, 219 or bond pad 419) and a second shunt capacitor (e.g., capacitor 116, 216, 416) between the second and third inductances, and a third intermediate node (e.g., node 118, 218 or bond pad 418) and a third shunt capacitor (e.g., capacitor 115, 215, 415) between the third and fourth inductances. Point 660 corresponds to the extrinsic impedance (Zsource_extrinsic) at the transistor gate, and the first series inductance results in a first impedance transformation to point 661. The first shunt capacitor results in a second impedance transformation from point 661 to point 662. The second series inductance results in a third impedance transformation from point 662 to point 663. The second shunt capacitor results in a fourth impedance transformation from point 663 to point 664. The third series inductance results in a fifth impedance transformation from point 664 to point 665. The third shunt capacitor results in a sixth impedance transformation from point 665 to point 667. Finally, the fourth series inductance results in a seventh impedance transformation from point 667 to point 668, where point 668 corresponds to the impedance at the lead plane.

As indicated in dashed box 670, the characteristics of the triple input T-match circuit causes the impedance trajectory to remain inside the quality circle 601. This is due to the inclusion of the additional matching stage, which enables relatively low inductances for the third and fourth series inductances (e.g., relatively short wirebonds between the input lead and the second intermediate node). Accordingly, in comparing the performances of the double input T-match circuit and the triple input T-match circuit, the triple input T-match circuit may benefit from an improved Q factor, higher gain, and higher real part impedance at the lead plane (thus making PCB matching easier).

The preceding detailed description is merely illustrative in nature and is not intended to limit the embodiments of the subject matter or the application and uses of such embodiments. As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, or detailed description.

The connecting lines shown in the various figures contained herein are intended to represent exemplary functional relationships and/or physical couplings between the various elements. It should be noted that many alternative or additional functional relationships or physical connections may be present in an embodiment of the subject matter. In addition, certain terminology may also be used herein for the purpose of reference only, and thus are not intended to be limiting, and the terms "first," "second" and other such numerical terms referring to structures do not imply a sequence or order unless clearly indicated by the context.

As used herein, a "node" means any internal or external reference point, connection point, junction, signal line, conductive element, or the like, at which a given signal, logic level, voltage, data pattern, current, or quantity is present. Furthermore, two or more nodes may be realized by one physical element (and two or more signals can be multiplexed, modulated, or otherwise distinguished even though received or output at a common node).

The foregoing description refers to elements or nodes or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with, electrically or otherwise) another element, and not necessarily mechanically. Thus, although the schematic shown in the figures depict one exemplary arrangement of elements, additional intervening elements, devices, features, or components may be present in an embodiment of the depicted subject matter.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

## Claims

1. A radio frequency, RF, power amplifier (100, 200) comprising:
a first amplification path (108, 208, 308) with a first amplifier input (102, 202, 302) and a first amplifier output (104, 204, 304);
a first transistor (130, 230, 530) with a first transistor input terminal (132, 232, 432) and a first transistor output terminal (134, 234); and
a first input impedance matching circuit (110, 210, 310) coupled between the first amplifier input and the first transistor input terminal, wherein the first input impedance matching circuit includes
a first inductive element (111, 211, 411) coupled between the first amplifier input and a first intermediate node (118, 218, 418),
a first capacitor (115, 215, 415) coupled between the first intermediate node and a ground reference node,
a second inductive element (112, 212, 412) coupled between the first intermediate node and a second intermediate node (119, 219, 419),
a second capacitor (116, 216, 416) coupled between the second intermediate node and the ground reference node,
a third inductive element (113, 213, 413) coupled between the second intermediate node and a third intermediate node (120, 220, 420),
a third capacitor (117, 217, 417) coupled between the third intermediate node and the ground reference node, and
a fourth inductive element (114, 214, 414) coupled between the third intermediate node and the first transistor input terminal (132, 232, 432).

2. The RF power amplifier of claim 1, further comprising:
a baseband termination circuit (122, 222, 322) connected to the third intermediate node, wherein the baseband termination circuit includes a plurality of components, and the plurality of components includes an envelope resistor (423), an envelope inductor (424), and an envelope capacitor (426) coupled in series between the third intermediate node and the ground reference node.

3. The RF power amplifier of claim 2, wherein the third intermediate node (120, 220, 420) is a quasi RF cold point node.

4. The RF power amplifier of claim 2 or 3, wherein the baseband termination circuit (122, 222, 322) further includes a bypass capacitor (425) coupled in parallel across one or more of the plurality of components of the baseband termination circuit.

5. The RF power amplifier of any preceding claim, wherein:
the first, second, third, and fourth inductive elements each have an inductance value in a range of 30 picohenries to 750 picohenries;
the first, second, and third capacitances each have a capacitance value in a range of 2 picofarads to 140 picofarads.

6. The RF power amplifier of any preceding claim, further comprising:
a first output impedance matching circuit (139, 240, 340) coupled between the first transistor output terminal and the first amplifier output, wherein the first output impedance matching circuit includes
a fifth inductive element (242) coupled between the first transistor output terminal and the first amplifier output,
a sixth inductive element (244) coupled between the first transistor output terminal and a fourth intermediate node (245), and
a fourth capacitor (246) coupled between the fourth intermediate node and the ground reference node.

7. The RF power amplifier of any preceding claim, further comprising:
a first output impedance matching circuit (139, 280, 380) coupled between the first transistor output terminal and the first amplifier output, wherein the first output impedance matching circuit includes
a fifth inductive element (282) coupled between the first transistor output terminal and a fourth intermediate node (283),
a fourth capacitor (286) coupled between the fourth intermediate node and the ground reference node, and
a sixth inductive element (284) coupled between the fourth intermediate node and the first amplifier output.

8. The RF power amplifier of any preceding claim, wherein the RF power amplifier is a Doherty power amplifier (200) further comprising:
a second amplification path (209, 309) with a second amplifier input (203, 303), a second amplifier output (205, 305), a second transistor (270), and a second input impedance matching circuit (250, 350);
a power divider (206) with a power divider input configured to receive an RF input signal, a first power divider output coupled to an input (202, 302) of the first amplification path, and a second power divider output coupled to the second amplifier input, wherein the power divider is configured to divide the RF input signal into a first RF signal that is provided to the first amplification path (208, 308) through the first power divider output, and into a second RF signal that is provided to the second amplification path (209, 309) through the second power divider output; and
a combining node (290) configured to receive and combine amplified RF signals produced by the first and second amplification paths.

9. The RF power amplifier of claim 8, wherein the Doherty power amplifier further comprises:
an impedance inversion and phase shift circuit (249) coupled between the first transistor output terminal (234) and the combining node (290).

10. The RF power amplifier of claim 8 or 9, wherein the second input impedance matching circuit (250, 350) comprises:
a fifth inductive element (251) coupled between the second amplifier input and a fourth intermediate node (258);
a fourth capacitor (255) coupled between the fourth intermediate node and the ground reference node;
a sixth inductive element (252) coupled between the fourth intermediate node and a fifth intermediate node (259);
a fifth capacitor (256) coupled between the fifth intermediate node and the ground reference node;
a seventh inductive element (253) coupled between the fifth intermediate node and a sixth intermediate node (260);
a sixth capacitor (257) coupled between the sixth intermediate node and the ground reference node; and
an eighth inductive element (254) coupled between the sixth intermediate node and a second transistor input terminal (272) of the second transistor (270).

11. A packaged radio frequency, RF, power amplifier device (300) comprising:
a device substrate (393);
a first input lead (302) coupled to the device substrate;
a first output lead (304) coupled to the device substrate;
and an RF power amplifier according to any preceding claim;
wherein
the first transistor input terminal (132, 232, 432) is coupled to the first input lead, and the first transistor output terminal (134, 234) is coupled to the first output lead.

12. The packaged RF power amplifier device of claim 11, wherein:
each of the first, second, third, and fourth inductive elements includes a plurality of wirebonds (411, 412, 413, 414).

13. The packaged RF power amplifier device of claim 11 or 12, further comprising:
one or more integrated passive devices (321) coupled to the device substrate between the first input lead and the first transistor die, wherein each of the first, second, and third capacitors (415, 416, 417) are integrally formed in the one or more integrated passive devices.

14. The packaged RF power amplifier device of claim 13, further comprising:
a first baseband termination circuit (122, 222, 322) integrally formed in the one or more integrated passive devices, wherein the first baseband termination circuit includes a first plurality of components, wherein the first plurality of components includes a first envelope resistor (423), a first envelope inductor (424), and a first envelope capacitor (426) coupled in series between the third intermediate node and the ground reference node.

15. The packaged RF power amplifier device of any of claims 11 to 14, further comprising:
a first output impedance matching circuit (139, 240, 280, 340, 380) coupled between the transistor output terminal (134, 234) and the first output lead (304).
